# EUROPEAN PATENT APPLICATION

(11) **EP 1 058 334 A2**
(43) Date of publication of application: **06.12.2000**
(21) Application number: 00110380.3
(22) Date of filing: 15.05.2000
(51) Int. Cl.: H01P 1/15, H01P 1/213

(54) **Frequency band variable filter, duplexer, and communication apparatus**

(30) Priority: 03.06.1999 JP 15634599
(71) Applicant: Murata Manufacturing Co., Ltd., Nagaokakyo-shi Kyoto-fu 617-8555 (JP)
(72) Inventor: Atokawa, Masayuki, c/o (A170) Int. Prop. Dept., Nagaokakyo-shi, Kyoto-fu 617-8555 (JP)
(74) Representative: Schoppe, Fritz, Dipl.-Ing.

(57) **Abstract**

There is disclosed a frequency band variable filter comprising: a plurality of resonators (R1, R2); a plurality of reactance elements respectively connected to the plurality of resonators via a plurality of switching elements (D11, D12); wherein a width of the frequency band in the on-state of the switching elements (D11, D12) is different from that in the off-state thereof.

## Description

### BACKGROUND OF THE PRESENT INVENTION

### 1. Field of the Invention

The present invention relates to filters and duplexers, whose frequency bands are variable, and communication apparatuses using the same.

### 2. Description of the Related Art

There are known frequency characteristic variable filters, in which reactance elements such as capacitors are connected to resonators via diodes to control voltages applied to the diodes so as to vary the resonance frequencies of the resonators (cf. Japanese Unexamined Patent Application Publication No. 63-90901 and Japanese Unexamined Patent Application Publication No. 7-321509).

When PIN diodes are used as the above diodes, since the resonant frequencies are switched according to the on/off states of the PIN diodes, the frequency characteristics of a filter have two bands according to the on/off states thereof.

Meanwhile, in a certain communication system used by switching (shifting) a transmission frequency band and a reception frequency band, when the frequency characteristics of a transmission filter and a reception filter are shifted by switching the diodes, the transmission filter and the reception filter can be used in the two bands.

For example, in a case of the PCS system as one of cellular phone systems, the transmission side has an overall bandwidth ranging from 1850 to 1910 MHz, and the reception side has an overall bandwidth ranging from 1930 to 1990 MHz. In this case, an arrangement can be made to shift the frequency characteristics of the filters between the on-state and off-state of the diodes in such a manner that the transmission side can be divided into two bandwidths ranging from 1850 to 1880 MHz and 1880 to 1910 MHz, and the reception side can be divided into two bandwidths ranging from 1930 to 1960 MHz and 1960 to 1990 MHz.

However, in the filter in which the frequency characteristics are shifted by the state of the diode, when the diode is in an on-state, the diode acts as a resistor having a specified resistance value, and when the diode is in an off-state, the diode acts as a capacitor having a relatively high Q₀ factor. As a result, according to the on/off state of the diode, the Q₀ factor of a resonance circuit changes. In a measurement performed by the inventor, in the case of a resonance circuit, in which the capacitance of a capacitor is set in such a manner that a dielectric resonator of a 1800 MHz band having a Q₀ factor of 350 is shifted by 30 MHz, and the capacitor is connected to the dielectric resonator via a diode, it was shown that the Q₀ factor of the resonance circuit was approximately 290 when the diode was in an off-state, and the Q₀ factor thereof was approximately 220 when the diode was in an on-state, by which the Q₀ factor decreases to approximately 75%. It was also found that, when a decrease in the Q₀ factor was similarly measured by using various kinds of switching elements such as diodes used in high frequencies, the Q₀ factor of the resonance circuit obtained in the on-state of the switching element with respect to the off-state thereof was in a range of approximately 75 to 95%.

Therefore, in the case of a duplexer used in the above PCS system, insertion loss occurring when the diode is in an on-state becomes greater than that occurring when the diode is in an off-state, thereby deteriorating a balance between the insertion losses caused by shifting of pass bands.

In order to solve this problem, separate filters corresponding to the pass bands can be used. However, as a result, since the number of components and the area occupied by the components on a printed circuit board increase, the size of the duplexer also increases. In addition, a switching circuit for selectively using the two filters is necessary.

### SUMMARY OF THE INVENTION

To overcome the above described problems, preferred embodiments of the present invention provide a frequency band variable filter and a duplexer, in which stable insertion-loss characteristics can be obtained regardless of the on/off state of a switching element in a frequency band variable filter shifting frequency bands according to the state of the switching element such as a diode, and to also provide a communication apparatus using the same.

One preferred embodiment of the present invention provides a frequency band variable filter comprising: a plurality of resonators; a plurality of reactance elements respectively connected to the plurality of resonators via a plurality of switching elements; wherein a width of the frequency band in the on-state of the switching elements is different from that in the off-state thereof.

According to the above arrangement, since an appropriate frequency bandwidth can be determined according to the on/off states of the switching elements shifting the resonant frequencies of the plurality of the resonators, freedom in designing increases.

In the above described frequency band variable filter, a predetermined frequency band may be divided into a first band and a second band each having different bandwidths; the frequency bandwidth of the first band may be wider than that of the second band; the first band may be used as the frequency band in the off-state of the switching elements; and the second band may be used as the frequency band in the on-state of the switching elements.

According to the above arrangement, as the frequency bandwidth used when the switching elements are turned on is narrowed, insertion loss in the frequency band is relatively reduced. As a result, an unbalance between the insertion losses occurring in the frequency band according to changing of the on/off states of the switching elements can be suppressed. Thus, design of the transmission/reception circuit can be facilitated.

In the above described frequency band variable filter, the frequency bandwidth in the on-state of the switching elements may be set at values ranging from 75% to 95% of the frequency bandwidth in the off-state of the switching elements.

According to the above arrangement, since a Q₀ factor of the resonance circuit obtained when the switching elements are in the on-states is in a range of approximately 75 to 95% as compared with the case in which the switching elements are in the off-states, by determining the frequency bandwidth corresponding to that, insertion losses in the frequency band caused by shifting the on/off states of the switching elements are substantially equal to each other.

In the above described frequency band variable filter, the resonators may be dielectric coaxial resonators.

According to the above arrangement, the overall miniaturization can be achieved and the unloaded Q (Q₀) factor can be highly maintained.

Another preferred embodiment of the present invention provides a frequency band variable duplexer comprising the above described filter, used as a transmission filter and a reception filter.

According to the above arranegemt, when the reception frequency band and the transmission frequency band are each divided into two bands to be used in the case of a single duplexer, an unbalance between the insertion losses in the frequency band caused by changing the on/off states of the switching elements can be suppressed. As a result, designing of the transmission circuit and the reception circuit can be facilitated.

Yet another preferred embodiment of the present invention provides a communication apparatus comprising the frequency band variable filter or duplexer describe above.

According the above arrangement, a compact communication apparatus, in which there are few characteristic changes occurring by shifting the frequency bands, can be obtained.
Other features and advantages of the present invention will become apparent from the following description of the invention which refers to the accompanying drawings.

### BRIEF DESCRIPTION OF DRAWINGS

Fig. 1 is a circuit diagram of a duplexer according to an embodiment of the present invention.
Fig. 2A, Fig. 2B and Fig. 2C show views illustrating the operations of the duplexer shown in Fig. 1.
Fig. 3 is a view showing pass characteristics of the reception filter and the transmission filter of the duplexer shown in Fig. 1.
Fig. 4 is a view showing the pass characteristics of the reception filter and the transmission filter of a duplexer according to another embodiment of the present invention.
Fig. 5 is a block diagram of a communication apparatus.

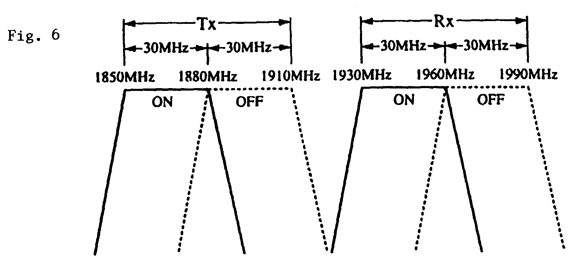

Fig. 6 is a view showing pass characteristics of the reception filter and the transmission filter of a prior art duplexer.

### DESCRIPTION OF THE PREFERRED EMBODIMENTS

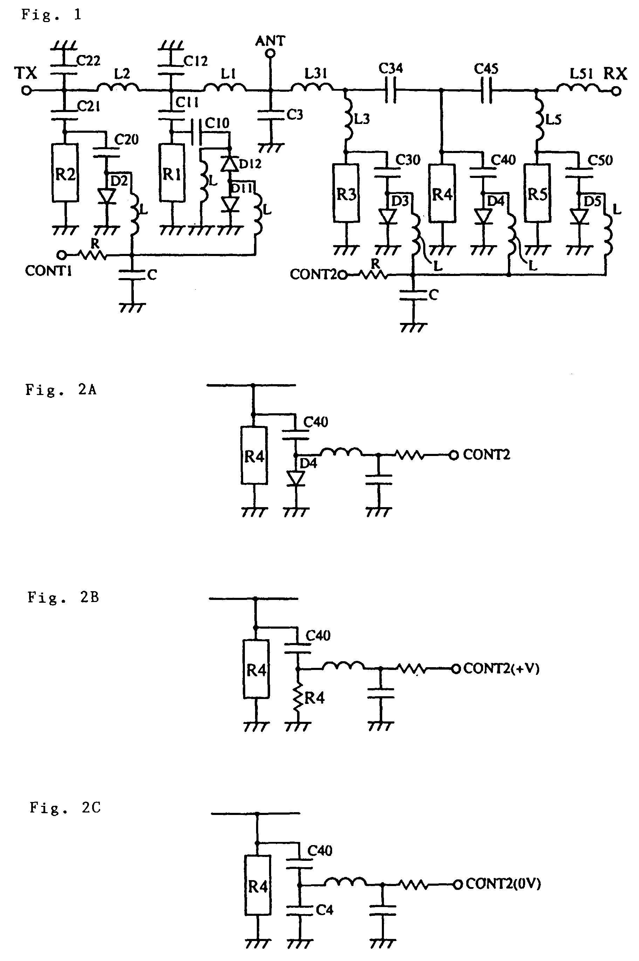

The structure of a duplexer according to an embodiment of the present invention will be illustrated with reference to Figs. 1 to 3.

Fig. 1 shows a circuit diagram of the duplexer. In this figure, reference character TX denotes a transmission signal input port, reference character RX denotes a reception signal output port, reference character ANT denotes an antenna port. In addition, reference numeral CONT1 is a control signal input terminal for a transmission filter, and reference numeral CONT2 is a control signal input terminal for a reception filter. Switching voltages applied to these control terminals shifts the frequency characteristics of the transmission filter and the reception filter.

In Fig. 1, reference numerals R1 and R2 denote dielectric coaxial resonators of the transmission filter. One end of each of the resonators R1 and R2 is grounded, and capacitors C11, C12, C21, and C22 are connected between the other ends thereof and the grounds. In addition, between the junctions of these parts, an inductor L2 is connected. With this arrangement, a band-elimination filter (BEF), in which the resonant frequencies of the resonators R1 and R2 are attenuation poles, is formed.

Meanwhile, R3, R4, and R5 denote dielectric coaxial resonators of the reception filter. One end of each of the resonators is grounded, and the other end thereof is connected to each other via capacitors C34 and C45, and inductors L3 and L5. This structure permits a band pass filter (BPF) constituted of a three-stage resonator to be formed. At an output of the reception filter, an inductor L51 is disposed.

Inductors L1 and L31, and a capacitor C3 form a phase composition circuit, which prevents a transmission signal from entering a reception filter and prevents a reception signal from entering a transmission filter so that branching of the transmission signal and the reception signal is performed.

Between the resonator R1 of the transmission filter and the ground, a series circuit of diodes D11 and D12, and a capacitor C10, is connected. In addition, between the resonator R2 and the ground, a series circuit of a diode D2 and a capacitor C20 is connected, and between the control signal input terminal CONT1 and the diodes D11, D12, and D2, a high-frequency blocking circuit composed of an inductor L, a resistor R, and a capacitor C is disposed. Similarly, in the reception filter, between the resonators R3, R4, and R5 and the grounds, a series circuit of a diode D3 and a capacitor C30, a series circuit of a diode D4 and a capacitor C40, and a series circuit of a diode D5 and a capacitor C50, respectively, are connected. Between the control signal input terminal CONT2 and the diodes D3, D4, and D5, a high-frequency blocking circuit constituted of an inductor L, a resistor R, and a capacitor C is disposed. As each diode above, for example, a PIN diode having good high-frequency characteristics is used. These diodes are equivalent to switching elements described in the present invention.

Figs. 2A, 2B and 2C are views illustrating a situation in which the resonant frequency of the resonator 4 shown in Fig. 1 is shifted according to the on/off state of a diode. In Fig. 2A, when a voltage applied to a CONT2 is set at a specified positive voltage, a series circuit composed of a capacitor C40 and a resistor R4 is equivalently connected parallel to the resonator R4, as shown in Fig. 2B. With this arrangement, the resonant frequency of the resonator R4 decreases. In addition, when the voltage applied to the CONT2 is set at 0V, with a blockage of the diode D4, by which the series circuit of the capacitors C40 and C4 is equivalently connected parallel to the resonator R4. This permits the resonant frequency of the resonator R4 to be increased.

Regarding the resonators R3 and R5 shown in Fig. 1, similarly, when a voltage applied to the CONT2 is set at a specified positive voltage, the resonant frequencies of R3 and R5 decrease, and when the voltage applied to the CONT2 is set at 0V, the resonant frequencies of R3 and R5 increase. In addition, regarding the resonators R1 and R2 shown in Fig. 1, similarly, when a voltage applied to a CONT1 is set at a specified positive voltage, the resonant frequencies of R1 and R2 decrease, and when the voltage applied to the CONT1 is set at 0V, the resonant frequencies of R1 and R2 increase.

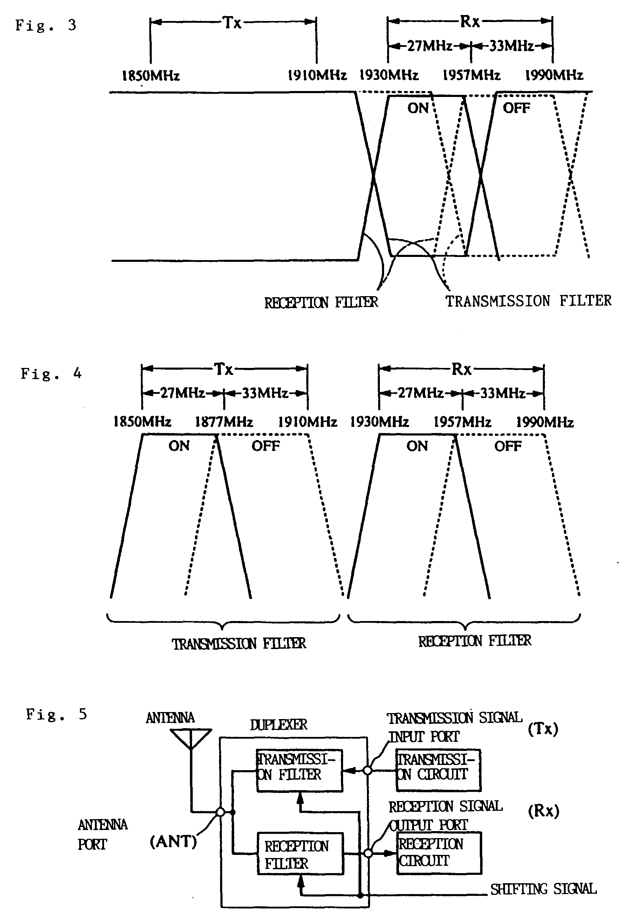

Fig. 3 illustrates pass characteristics of the transmission filter and the reception filter of the above duplexer. In this figure, reference character Rx denotes an overall reception frequency band, and reference character Tx denotes an overall transmission frequency band. A solid line indicates the pass characteristics obtained when each diode of the duplexer is in an on-state, and a broken line indicates the pass characteristics obtained when each diode thereof is in an off-state. When diodes D11, D12, D2, D3, D4, and D5 shown in Fig. 1 are turned on, the pass band of the reception filter and the block band of the transmission filter are in a range of 1930 to 1957 MHz. When the diodes D11, D12, D2, D3, D4, and D5 are turned off, the pass band of the reception filter and the block band of the transmission filter are in a range of 1957 to 1990 MHz.

In this way, the pass bandwidth used when the diodes of the reception filter are turned on is set at 27 MHz, and the pass bandwidth used when the diodes thereof are turned off is set at 33 MHz. That is, the pass bandwidth used when the diodes are in the on-state is set for approximately 82% of the pass bandwidth used when the diodes are in the off-state thereof. With this arrangement, insertion loss in the upper band of the reception band is made substantially equal to insertion loss in the lower band thereof.

The pass band of the reception filter is determined by setting the values of the coupling capacitors C34 and C45 between the resonators shown in Fig. 1. In addition, the block band of the transmission filter is determined by setting the values of L1, L2, C11, C12, C21, and C22 shown in Fig. 1.

In the example shown in Fig. 1, the reception filter is formed as a band pass filter, and the transmission filter is formed as a band block filter. However, both the reception filter and the transmission filter may be formed as band pass filters. Fig. 4 shows an example of pass bands of the transmission filter and the reception filter in this case. A solid line indicates the pass characteristics obtained when each diode of the duplexer is in an on-state, and a broken line indicates the pass characteristics obtained when each diode thereof is in an off-state. When the diodes of the reception filter are turned on, the pass band of the reception filter is in a range of 1930 to 1957 MHz. When the diodes of the reception filter are turned off, the pass band of the reception filter is in a range of 1957 to 1990 MHz. In addition, when the diodes of the transmission filter are turned on, the pass band of the transmission filter is in a range of 1850 to 1877 MHz, and when the diodes of the transmission filter are turned off, the pass band of the transmission filter is in a range of 1877 to 1910 MHz.

In this way, each of the pass bandwidths of the reception filter and the transmission filter when the diodes are turned on is set at 27 MHz, and each of the pass bandwidths thereof is set at 33 MHz when the diodes are turned off. That is, the pass bandwidths used when the diodes are turned on are equivalent to approximately 82% of the pass bandwidths used when the diodes are turned off. With this arrangement, insertion losses in the upper sides of the reception band and the transmission band are substantially equal to those in the lower bands thereof.

Fig. 5 shows a block diagram of a duplexer and a communication apparatus using the duplexer. This duplexer is a duplexer having a structure shown in Fig. 1, in which the frequency bands of the transmission filter and the reception filter are shifted by a shifting signal. As shown in this figure, a transmission circuit is connected to a transmission signal input port Tx, and a reception circuit is connected to a reception signal output port Rx. An antenna is connected to an antenna port ANT. This structure permits a communication apparatus to be formed.

In the transmission filter and the reception filter of the above duplexer, there are few changes in the insertion loss caused by shifting the frequency bands. As a result, gains of the transmission circuit and the reception circuit can be set common between the two bands shifted, thereby leading to an easy circuit design.

In the embodiments shown above, the PIN diodes are used as the switching elements. However, other switching elements such as transistors may be used.

While the invention has been particularly shown and described with reference to preferred embodiments thereof, it will be understood by those skilled in the art that the forgoing and other changes in form and details may be made therein without departing from the spirit of the invention.

## Claims

1. A frequency band variable filter comprising:
a plurality of resonators (R1, R2; R3, R4, R5);
a plurality of reactance elements respectively connected to the plurality of resonators via a plurality of switching elements (D11, D12; D2, D3, D4; D5);
wherein a width of the frequency band in the on-state of the switching elements (D11, D12; D2, D3, D4; D5) is different from that in the off-state thereof.

2. The frequency band variable filter according to Claim 1, wherein a predetermined frequency band is divided into a first band and a second band each having different bandwidths;
the frequency bandwidth of the first band is wider than that of the second band;
the first band is used as the frequency band in the off-state of the switching elements (D11, D12; D2-D5); and
the second band is used as the frequency band in the on-state of the switching elements (D11, D12; D2-D5) .

3. The frequency band variable filter according to Claim 2, wherein the frequency bandwidth in the on-state of the switching elements (D11, D12; D2-D5) is set at values ranging from 75% to 95% of the frequency bandwidth in the off-state of the switching elements (D11, D12; D2-D5) .

4. The frequency band variable filter according to any of Claims 1-3, wherein the resonators (R1, R2; R3-R5) are dielectric coaxial resonators.

5. A frequency band variable duplexer comprising the filter of any of Claims 1-4, used as a transmission filter and a reception filter.

6. A communication apparatus comprising the frequency band variable filter of any of Claims 1-4.

7. A communication apparatus comprising the frequency band variable duplexer of Claim 5.
